# EUROPEAN PATENT APPLICATION

(11) **EP 4 411 798 A1**
(43) Date of publication of application: **07.08.2024**
(21) Application number: 22875408.1
(22) Date of filing: 23.03.2022
(51) Int. Cl.: H01L 21/76, H01L 27/146

(54) **IMAGING ELEMENT, IMAGING DEVICE AND PRODUCTION METHOD**

(30) Priority: 29.09.2021 JP 2021158910
(71) Applicant: Sony Semiconductor Solutions Corporation, Atsugi-shi, Kanagawa 243-0014 (JP)
(72) Inventor: FUKATANI Takashi, Atsugi-shi, Kanagawa 243-0014 (JP); FUJII Nobutoshi, Atsugi-shi, Kanagawa 243-0014 (JP); SAITO Suguru, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/013557
(87) International publication number: WO 2023/053525

(57) **Abstract**

The present technology relates to an imaging element, an imaging device, and a manufacturing method that make it possible to miniaturize and configure the imaging element in such a manner as to prevent embedding failure from occurring when embedding a filler in an inter-pixel separation section during manufacture.

The imaging element includes a substrate, a photoelectric conversion region, and an inter-pixel separation section. The photoelectric conversion region is disposed on the substrate. The inter-pixel separation section is disposed on the substrate and positioned between photoelectric conversion regions adjacent to each other. An opening in the inter-pixel separation section has an inclined surface formed by a (111) plane. The inclined surface is positioned toward a light-incident surface and provided on both ends of the inter-pixel separation section or is positioned toward the light-incident surface and provided on one end of the inter-pixel separation section. The present technology is applicable, for example, to imaging elements.

## Description

### [Technical Field]

The present technology relates to an imaging element, an imaging device, and a manufacturing method, and more particularly relates, for example, to an imaging element, an imaging device, and a manufacturing method that are capable of suppressing embedding failure during manufacture.

### [Background Art]

Imaging elements are required to be smaller in size and include a larger number of pixels. Therefore, the pixels are increasingly miniaturized. However, while sensitivity decreases as the pixels are miniaturized, it is demanded that the sensitivity be increased by compensating for sensitivity decrease due to a decrease in an aperture ratio. Proposed for the purpose of increasing the sensitivity of each pixel in an imaging element is a technology that forms a P-type diffusion layer and an N-type diffusion layer on a sidewall of a trench formed between the individual pixels, to create a strong electric field region and retain charge.

PTL 1 proposes a structure that prevents weakening of pinning of charge, appearance of a white spot, and generation of dark current.

### [Citation List]

### [Patent Literature]

[PTL 1]
Japanese Patent Laid-open No. 2018-148116

### [Summary]

### [Technical Problem]

As the imaging elements are increasingly miniaturized, the trench itself formed between the individual pixels is also miniaturized. As the trench is miniaturized, a line width (opening) of the trench becomes narrower, which may cause embedding failure at the time of embedding a filler during manufacture. Even in the case of miniaturization, it is desired that, for example, embedding failure be avoided.

The present technology has been made in view of the above circumstances. An object of the present technology is to avoid failure of embedding a filler in the trench.

### [Solution to Problem]

An imaging element according to an aspect of the present technology includes a photoelectric conversion region that is provided on a substrate, and an inter-pixel separation section that is disposed on the substrate and positioned between the photoelectric conversion regions adjacent to each other, in which an opening in the inter-pixel separation section has an inclined surface, and the inclined surface is formed by a (111) plane.

An imaging device according to an aspect of the present technology includes an imaging element that includes a photoelectric conversion region that is provided on a substrate, and an inter-pixel separation section that is disposed on the substrate and positioned between the photoelectric conversion regions adjacent to each other, an opening in the inter-pixel separation section having an inclined surface formed by a (111) plane, and a processing section that processes signals from the imaging element.

A manufacturing method according to an aspect of the present technology for manufacturing an imaging element that includes a photoelectric conversion region that is provided on a substrate and an inter-pixel separation section that is disposed on the substrate and positioned between the photoelectric conversion regions adjacent to each other, the manufacturing method including forming a hole, with a line width greater than a line width of the inter-pixel separation section, in a hard mask formed as a film on the substrate, and forming an inclined surface on the inter-pixel separation section by performing etching with an alkaline chemical solution.

The imaging element according to an aspect of the present technology includes a photoelectric conversion region and an inter-pixel separation section. The photoelectric conversion region is provided on a substrate. The inter-pixel separation section is disposed on the substrate and positioned between the photoelectric conversion regions adjacent to each other. An opening in the inter-pixel separation section has an inclined surface. The inclined surface is formed by a (111) plane.

The imaging device according to an aspect of the present technology includes the imaging element.

The manufacturing method according to an aspect of the present technology is used to manufacture an imaging element that includes a photoelectric conversion region and an inter-pixel separation section. The photoelectric conversion region is provided on a substrate. The inter-pixel separation section is disposed on the substrate and positioned between the photoelectric conversion regions adjacent to each other. The manufacturing method forms a hole, with a line width greater than the line width of the inter-pixel separation section, in a hard mask formed as a film on the substrate, and forms an inclined surface on the inter-pixel separation section by performing etching with an alkaline chemical solution.

It should be noted that the imaging device may be an independent device or an internal block included in one device.

### [Brief Description of Drawings]

[FIG. 1]

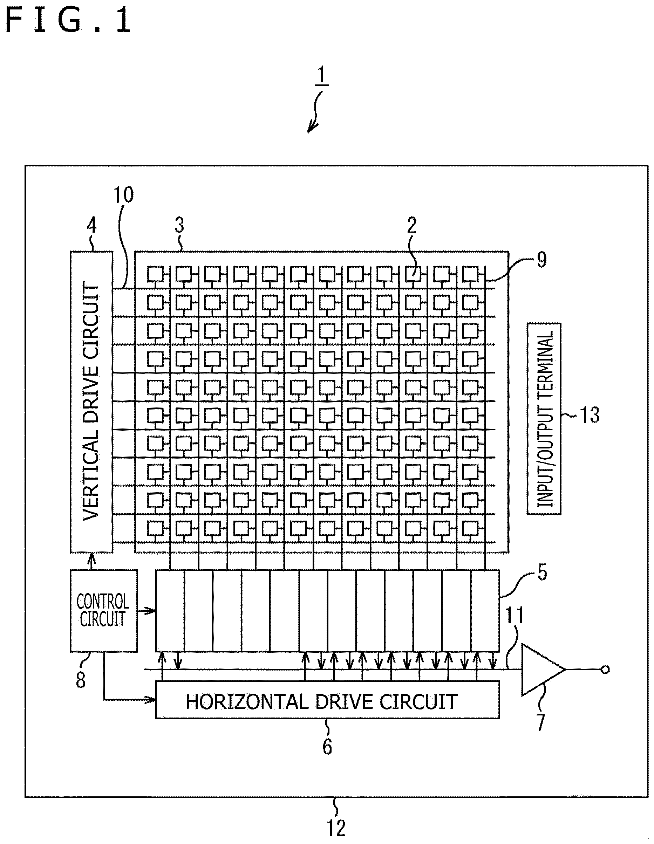

   FIG. 1 is a diagram illustrating a schematic configuration of an imaging device according to the present disclosure.
[FIG. 2]

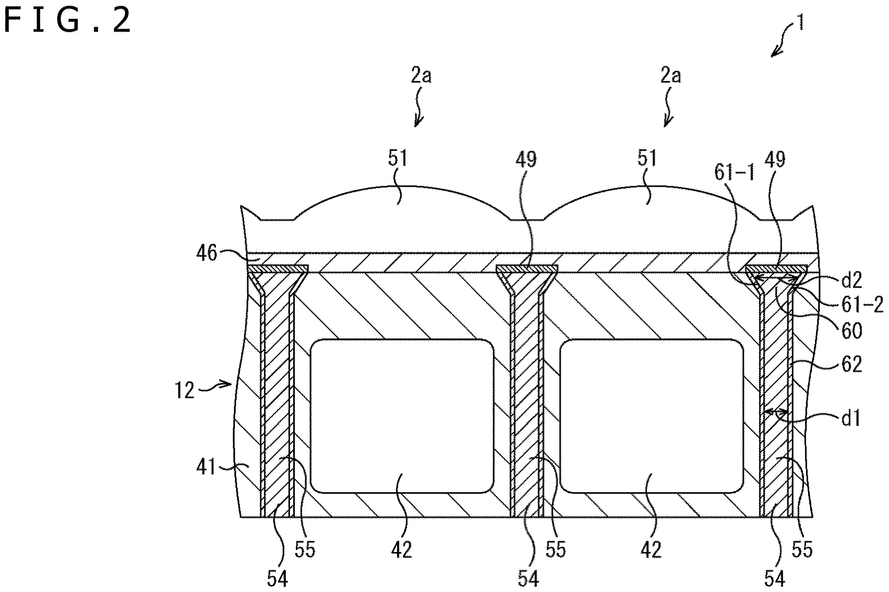

   FIG. 2 is a diagram illustrating an example of the cross-sectional configuration of a pixel according to a first embodiment.
[FIG. 3]

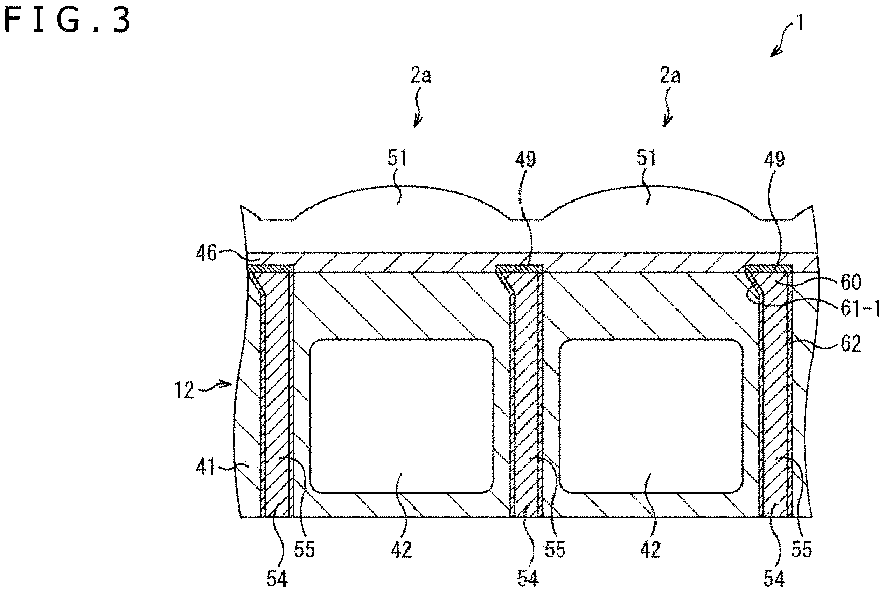

   FIG. 3 is a diagram illustrating another example of the cross-sectional configuration of the pixel according to the first embodiment.
[FIG. 4]

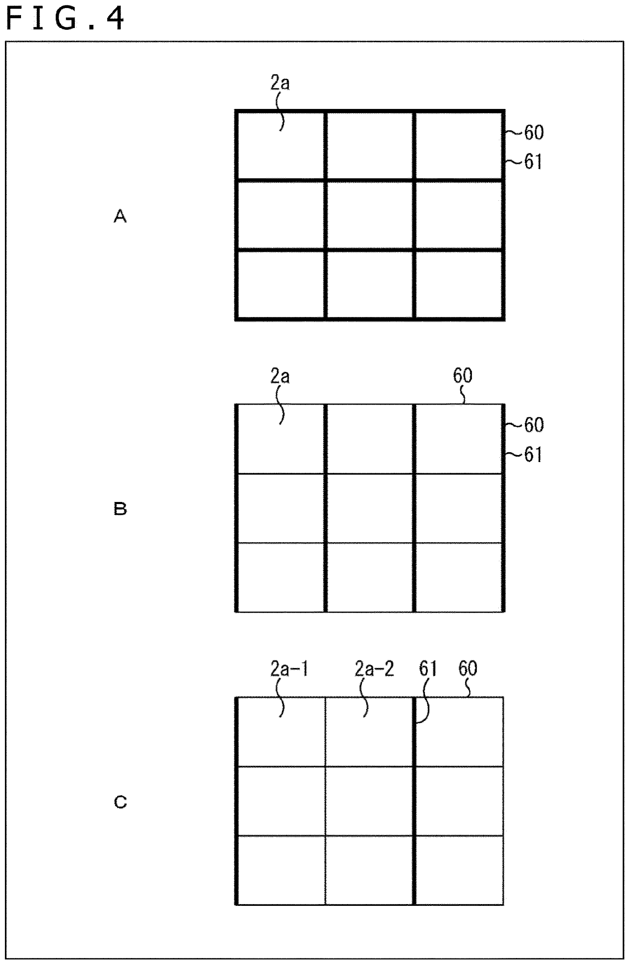

   FIG. 4 is a diagram illustrating sides where an opening is disposed.
[FIG. 5]

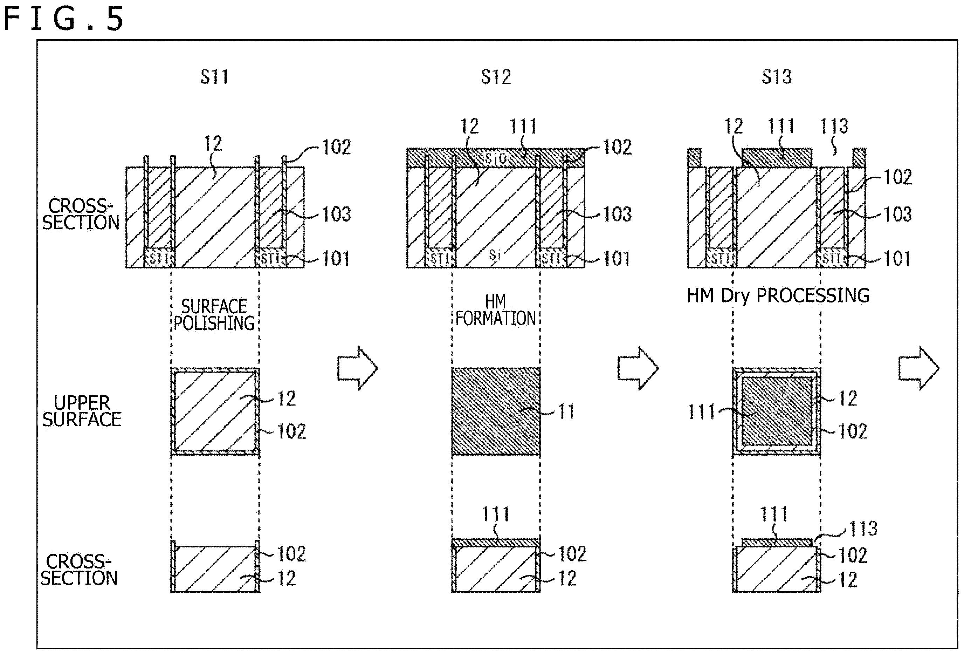

   FIG. 5 is a diagram illustrating the manufacture of the pixel.
[FIG. 6]

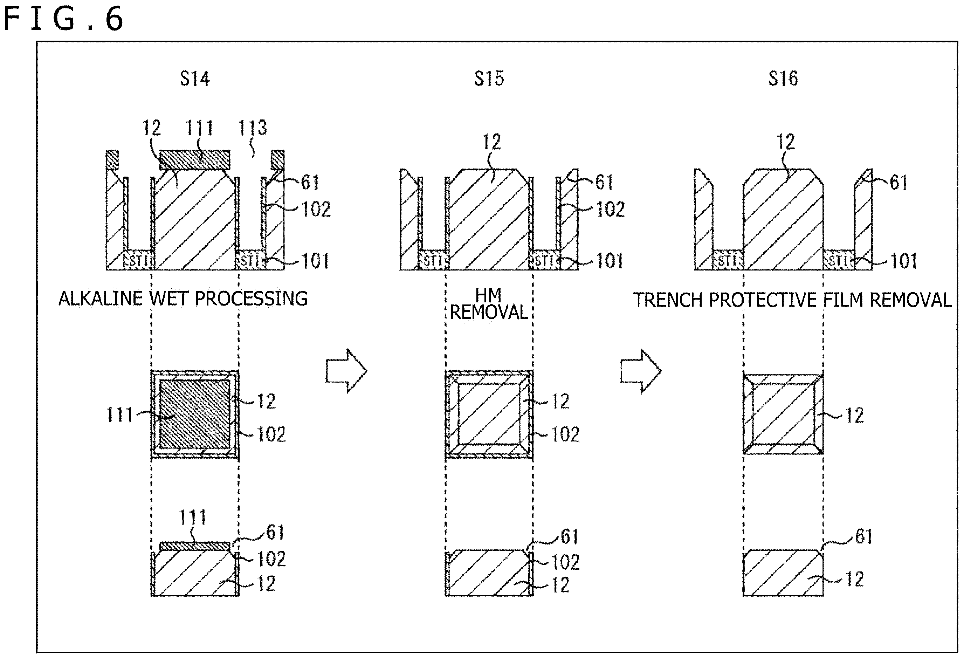

   FIG. 6 is a diagram illustrating the manufacture of the pixel.
[FIG. 7]

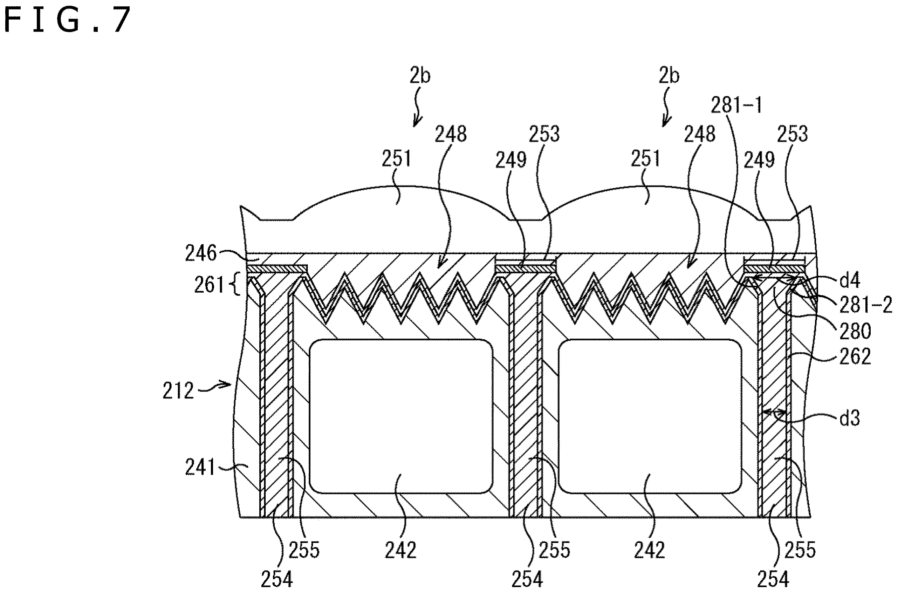

   FIG. 7 is a diagram illustrating an example of the cross-sectional configuration of a pixel according to a second embodiment.
[FIG. 8]

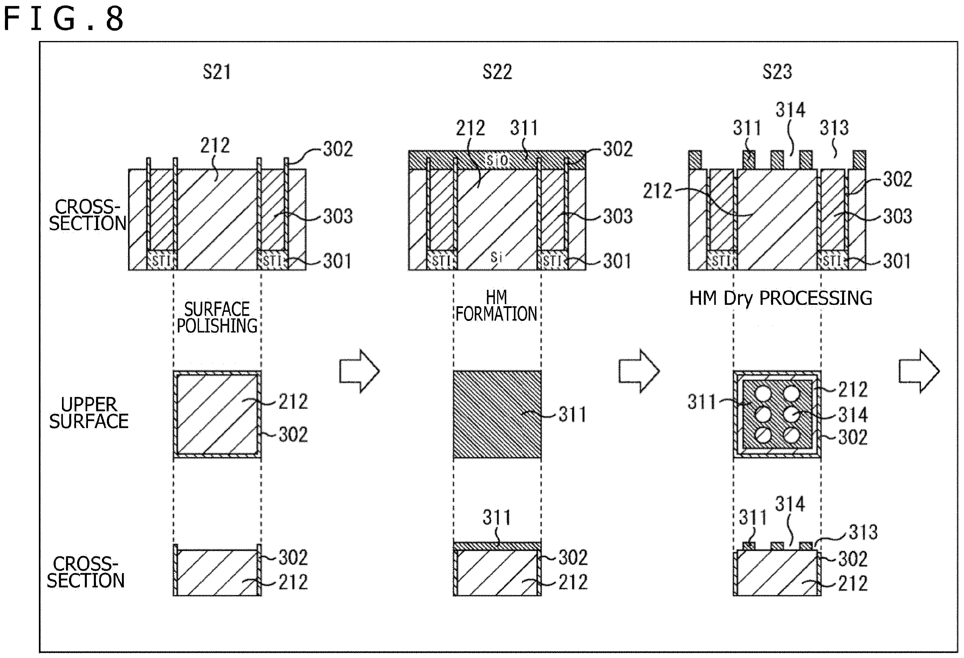

   FIG. 8 is a diagram illustrating the manufacture of the pixel.
[FIG. 9]

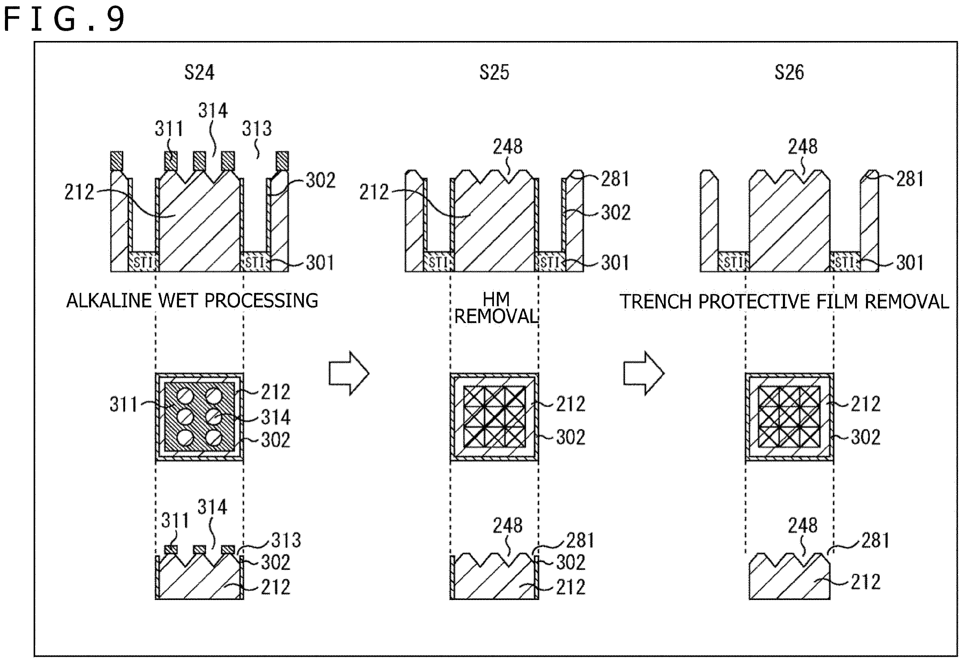

   FIG. 9 is a diagram illustrating the manufacture of the pixel.
[FIG. 10]

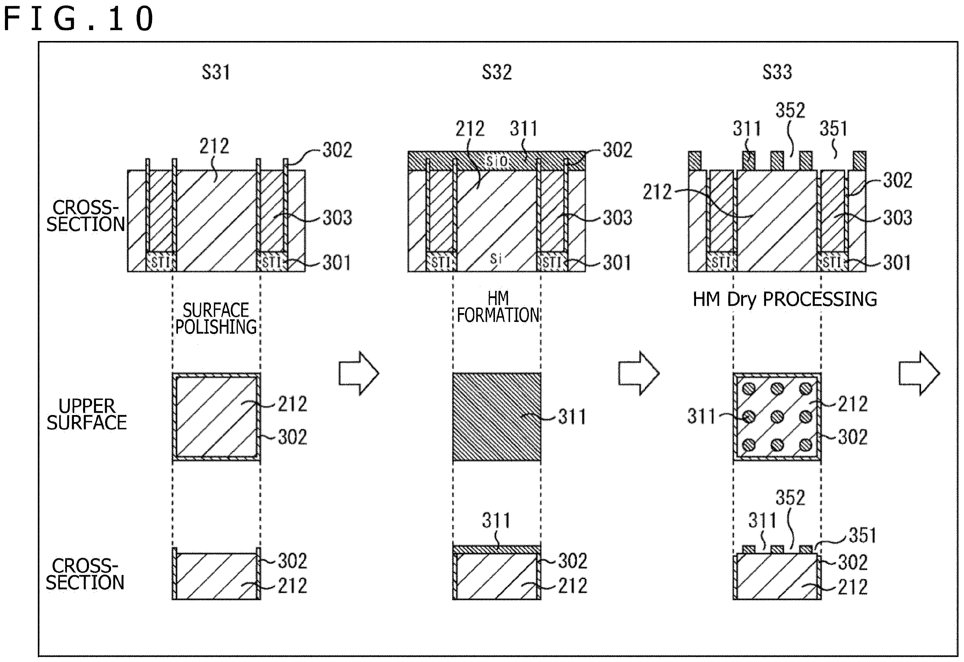

   FIG. 10 is a diagram illustrating the manufacture of the pixel.
[FIG. 11]

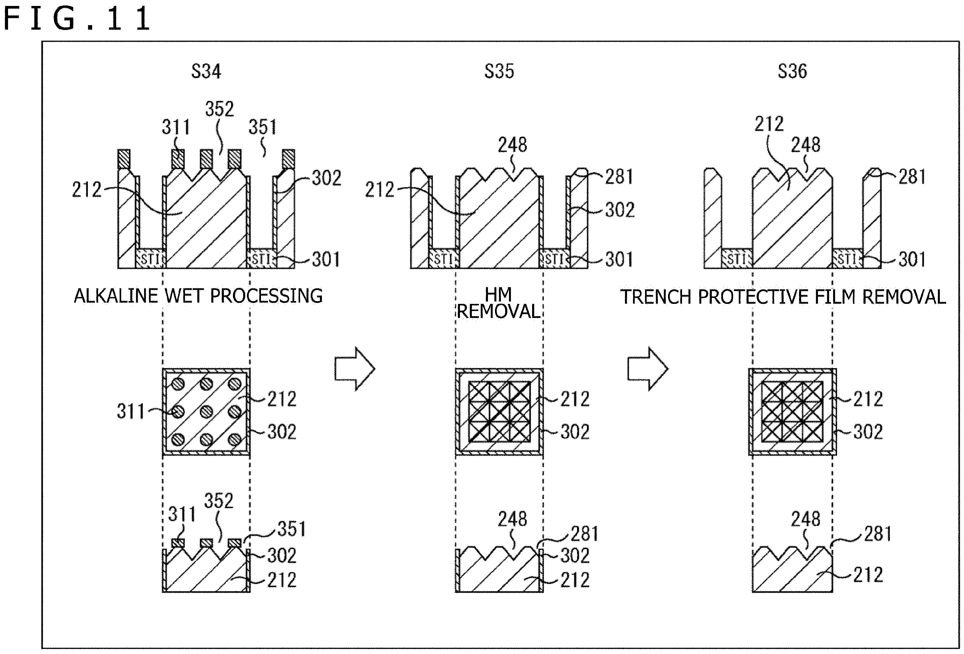

   FIG. 11 is a diagram illustrating the manufacture of the pixel.
[FIG. 12]

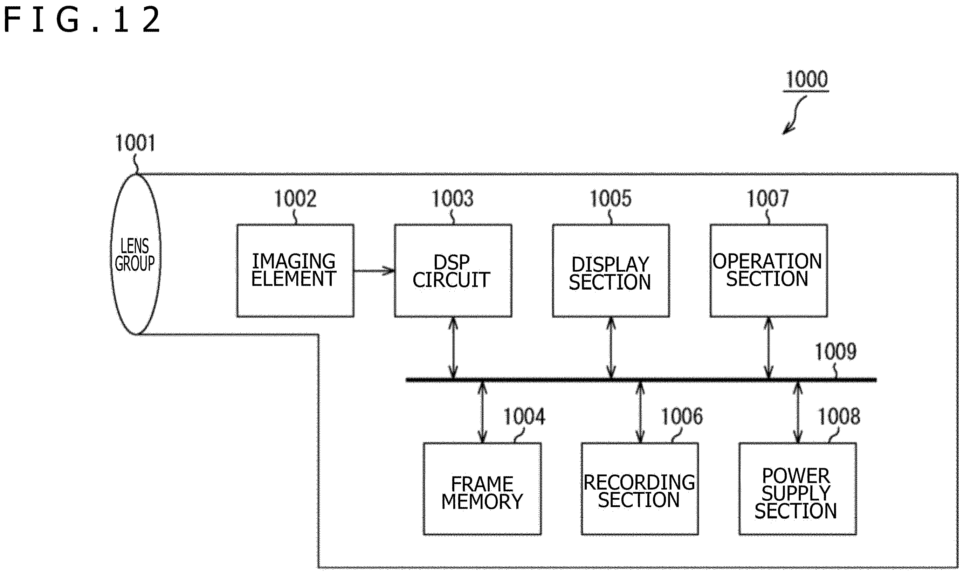

   FIG. 12 is a diagram illustrating a configuration of electronic equipment.
[FIG. 13]

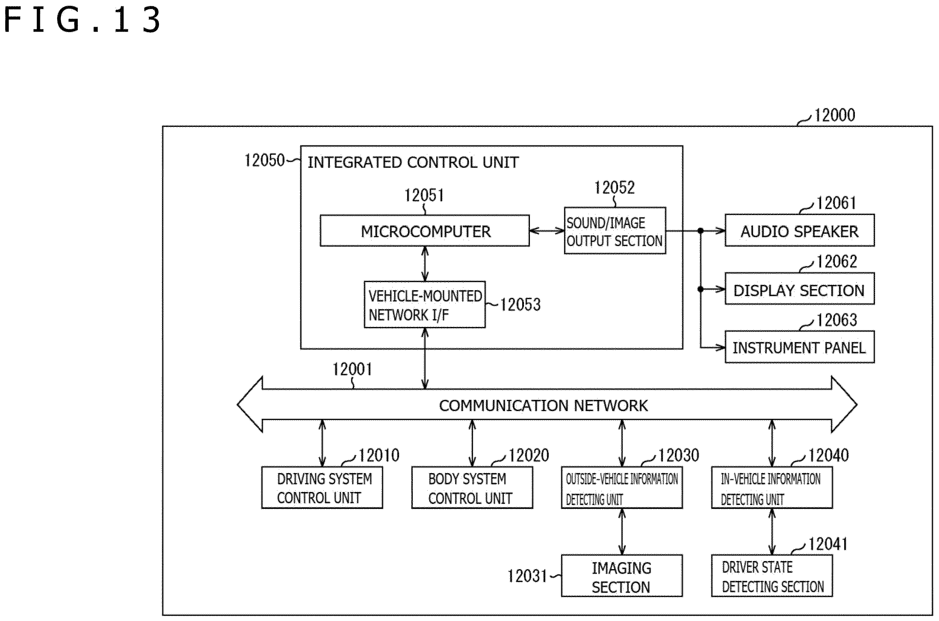

   FIG. 13 is a block diagram depicting an example of schematic configuration of a vehicle control system.
[FIG. 14]

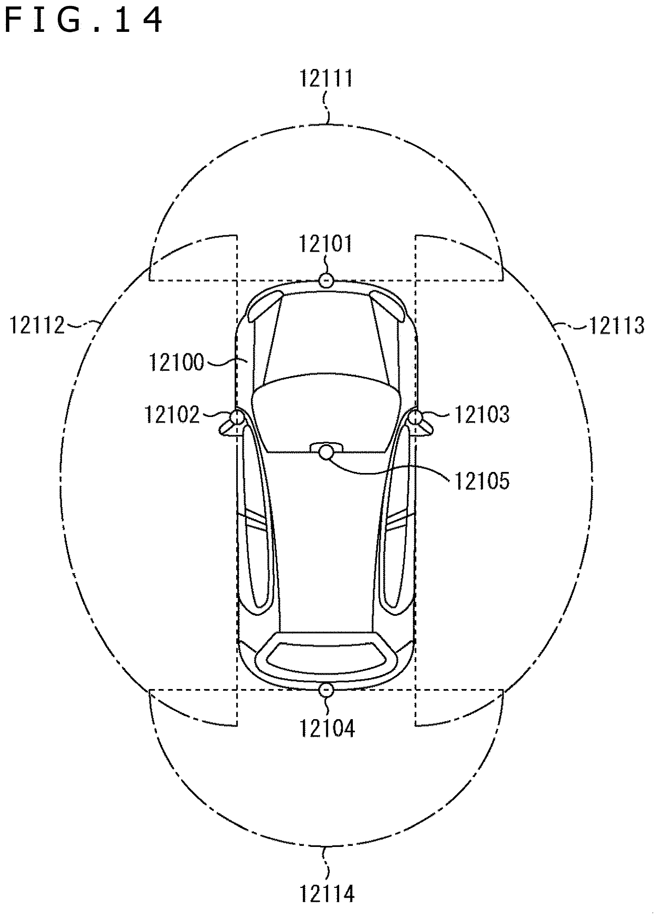

   FIG. 14 is a diagram of assistance in explaining an example of installation positions of an outside-vehicle information detecting section and an imaging section.

### [Description of Embodiments]

Modes for implementing the present technology (hereinafter referred to as embodiments) will now be described.

### <Example of Schematic Configuration of Imaging Device>

FIG. 1 illustrates a schematic configuration of an imaging device according to the present disclosure.

The imaging device 1 depicted in FIG. 1 includes a pixel array section 3 and a peripheral circuit section. The pixel array section 3 is disposed on a semiconductor substrate 12, and configured such that pixels 2 are arranged in a two-dimensional array. The semiconductor substrate 12 uses silicon (Si) as a semiconductor. The peripheral circuit section, which is disposed around the pixel array section 3, includes, for example, a vertical drive circuit 4, a column signal processing circuit 5, a horizontal drive circuit 6, an output circuit 7, and a control circuit 8.

The pixels 2 each include a photodiode and a plurality of pixel transistors. The photodiode is used as a photoelectric conversion element. The plurality of pixel transistors include, for example, four MOS transistors, namely, a transfer transistor, a selection transistor, a reset transistor, and an amplification transistor.

The pixels 2 may have a shared pixel structure. The shared pixel structure, which is a pixel-sharing structure, includes a plurality of photodiodes, a plurality of transfer transistors, one shared floating diffusion (floating diffusion region), and one each of other shared pixel transistors. That is, in a shared pixel, the photodiodes and the transfer transistors, which are included in a plurality of unit pixels, are configured to share one each of other pixel transistors.

The control circuit 8 receives an input clock as well as data designating, for example, an operation mode, and outputs data such as internal information regarding the imaging device 1. More specifically, based on a vertical synchronization signal, a horizontal synchronization signal, and a master clock, the control circuit 8 generates clock signals and control signals that provide an operating reference, for example, for the vertical drive circuit 4, the column signal processing circuit 5, and the horizontal drive circuit 6. Subsequently, the control circuit 8 outputs the generated clock signals and control signals, for example, to the vertical drive circuit 4, the column signal processing circuit 5, and the horizontal drive circuit 6.

The vertical drive circuit 4, which is formed, for example, by a shift register, selects a pixel drive wiring 10, supplies a pulse for driving the pixels 2 to the selected pixel drive wiring 10, and drives the pixels 2 row by row. More specifically, the vertical drive circuit 4 sequentially performs a selective scan of each pixel 2 in the pixel array section 3 in the vertical direction row by row, supplies a pixel signal based on signal charge, which is generated by the photoelectric conversion section of each pixel 2 according to the amount of light received, to the column signal processing circuit 5 through a vertical signal line 9.

The column signal processing circuit 5, which is disposed for each column of pixels 2, performs signal processing, such as noise removal, on signals outputted from one row of pixels 2 for each pixel column. For example, the column signal processing circuit 5 performs signal processing, such as CDS (Correlated Double Sampling) for removing pixel-specific fixed-pattern noise, and AD conversion.

The horizontal drive circuit 6, which is formed, for example, by a shift register, sequentially outputs horizontal scanning pulses to select each column signal processing circuit 5 in turn, and causes each column signal processing circuit 5 to output the pixel signal to a horizontal signal line 11.

The output circuit 7 performs signal processing on the signals sequentially supplied from each column signal processing circuit 5 through the horizontal signal line 11, and outputs the processed signals. For example, the output circuit 7 may perform only buffering or may perform signal processing, such as black level adjustment, column variation correction, and various digital signal processing operations. An input/output terminal 13 exchanges signals with the outside.

The imaging device 1 configured as described above is a CMOS image sensor that is based on a column AD method in which the column signal processing circuit 5 for performing CDS processing and AD conversion processing is disposed for each pixel column.

The imaging device 1 is a back-illuminated MOS imaging device that is configured to allow light to enter from a back side opposite to a front side of the semiconductor substrate 12 on which the pixel transistors are formed.

### <First Embodiment>

FIG. 2 is a diagram illustrating an example of the cross-sectional configuration of a pixel 2a according to a first embodiment.

The imaging device 1 includes the semiconductor substrate 12, a multilayer wiring layer formed on the front side of the semiconductor substrate 12, and a support substrate (the latter two component elements are not depicted).

The semiconductor substrate 12 is formed, for example, by silicon (Si). The semiconductor substrate 12 is configured such that, for example, an N-type (second conductivity type) semiconductor region 42 is formed in a P-type (first conductivity type) semiconductor region 41 for each pixel 2a so as to form a photodiode PD (photoelectric conversion region) pixel by pixel. The P-type semiconductor region 41, which is provided on both the front and back surfaces of the semiconductor substrate 12, doubles as a hole charge accumulation region for suppressing dark current.

As depicted in FIG. 2, the imaging device 1 includes a transparent insulating film 46 and an on-chip lens 51. The transparent insulating film 46 and the on-chip lens 51 are stacked on the semiconductor substrate 12 on which the N-type semiconductor region 42 included in a photodiode PD is formed for each pixel 2a.

A light-shielding film 49 is formed between the transparent insulating film 46 and the interface (light-receiving side interface) of the P-type semiconductor region 41 above the N-type semiconductor region 42, which serves as a charge accumulation region. As the light-shielding film 49, a single layer metal film such as titanium (Ti), titanium nitride (TiN), tungsten (W), aluminum (Al), or tungsten nitride (WN) is used. Alternatively, a stacked film of these metals (e.g., a stacked film of titanium and tungsten or a stacked film of titanium nitride and tungsten) may be used as the light-shielding film 49.

The transparent insulating film 46 is formed on the entire back side (light-incident side) of the P-type semiconductor region 41. The transparent insulating film 46 is a material that transmits light, has insulating properties, and has a refractive index n1 smaller than the refractive index n2 of the semiconductor regions 41 and 42 (n1 < n2). As materials for the transparent insulating film 46, for example, silicon oxide (SiO2), silicon nitride (SiN), silicon oxynitride (SiON), hafnium oxide (HfO2), aluminum oxide (Al2O3), zirconium oxide (ZrO2), tantalum oxide (Ta2O5), titanium oxide (TiO2), lanthanum oxide (La2O3), praseodymium oxide (Pr2O3), cerium oxide (CeO2), neodymium oxide (Nd2O3), promethium oxide (Pm2O3), samarium oxide (Sm2O3), europium oxide (Eu2O3), gadolinium oxide (Gd2O3), terbium oxide (Tb2O3), dysprosium oxide (Dy2O3), holmium oxide (Ho2O3), thulium oxide (Tm2O3), ytterbium oxide (Yb2O3), lutetium oxide (Lu2O3), yttrium oxide (Y2O3), and resin can be used alone or in combination.

A color filter layer may be formed above the transparent insulating film 46 including the light-shielding film 49. For example, a configuration may be adopted in which a red, green, or blue color filter layer is formed for each pixel.

On the transparent insulating film 46, the on-chip lens 51 is formed for each pixel 2a. The on-chip lens 51 is formed, for example, by a resin material such as styrene resin, acrylic resin, styrene-acrylic copolymer resin, or siloxane resin. The on-chip lens 51 collects incident light, and the collected incident light efficiently enters the photodiode PD.

For the pixels 2a depicted in FIG. 2, an inter-pixel separation section 54 is formed on the semiconductor substrate 12 to separate the pixels 2a from each other. The inter-pixel separation section 54 forms a trench that penetrates the semiconductor substrate 12 and is disposed between the N-type semiconductor regions 42 including the photodiode PD. A fixed charge film 62 is formed on the inner surface of the trench. The fixed charge film 62 is a film having positive or negative fixed charge.

For example, in a case where the element structure of the pixel 2a is of a hole readout type, positive fixed charge is applied to the fixed charge film 62. Specifically, as the fixed charge film 62, a silicon nitride film (SiN) or a silicon nitride oxide film (SiON) may be used. For example, in a case where the element structure of the pixel 2a is of an electronic readout type, negative fixed charge is applied to the fixed charge film 62. Specifically, as the fixed charge film 62, for example, a hafnium oxide film (HfO2), a zirconium dioxide film (ZrO2), an alumina film (AlO3), a titanium dioxide film (TiO2), or a tantalum pentoxide film (Ta2O5) may be used.

The inter-pixel separation section 54 is filled with a filler 55. As the filler 55 to be filled in the inter-pixel separation section 54, polysilicon or a material formed by hafnium oxide and silicon oxide may be used. A light-reflecting material, such as Al (aluminum), W (tungsten), Ti (titanium), Ta (tantalum), Cu (copper), Cr (chromium), Ni (nickel), Sn (tin), Si (silicon), or any of their compounds, may also be used as the filler 55.

Since the inter-pixel separation section 54 is configured as described above, adjacent pixels 2a are completely electrically isolated from each other by the filler 55 embedded in the trench. This makes it possible to prevent charge generated inside the semiconductor substrate 12 from leaking to the adjacent pixels 2a.

The inter-pixel separation section 54 (the trench constituting the inter-pixel separation section 54) may be configured to penetrate the semiconductor substrate 12 or configured to not penetrate the semiconductor substrate 12.

The inter-pixel separation section 54 for the pixels 2a depicted in FIG. 2 has a structure in which the filler 55 is easily filled into the trench during manufacture. A wide opening (referred to as an opening 60) is formed on the light-incident side of the inter-pixel separation section 54. When a portion of the inter-pixel separation section 54 other than the opening 60 has a width d1 and the widest portion of the opening 60 has a width d2, the inter-pixel separation section 54 is configured such that the relational expression width d1

### < width d2 is true.

The opening 60 has the width d2 at the interface with the light-shielding film 49 (transparent insulating film 46). Since the opening 60 is formed to be wide, it is possible to prevent, for example, embedding failure from occurring when embedding the filler 55 through the opening 60. It should be noted that the embedding failure is a situation where, for example, the trench of the inter-pixel separation section 54 is insufficiently filled with the filler 55 and provided with a gap or the filler 55 leaks into a portion that is not to be filled.

The opening 60 in the inter-pixel separation section 54 depicted in FIG. 2 has an enlarged opening 61-1 in a leftward direction in FIG. 2 and an enlarged opening 61-2 in a rightward direction in FIG. 2. The following relation holds true: width of enlarged opening 61-1 + width of enlarged opening 61-2 + width d1 = width d2.

The inter-pixel separation section 54 depicted in FIG. 2 is configured such that the enlarged openings 61-1 and 61-2 are provided respectively at left and right ends of the light-incident side of the inter-pixel separation section 54. However, the inter-pixel separation section 54 may alternatively be configured such that only the enlarged opening 61-1 is provided at one end of the light-incident side of the inter-pixel separation section 54 as depicted in FIG. 3.

Referring to FIG. 3, the opening 60 in the inter-pixel separation section 54 has the enlarged opening 61-1 on a left side of FIG. 3 and does not have the enlarged opening 61-2 on a right side of FIG. 3. FIG. 3 depicts the opening 60 that has the enlarged opening 61-1 on the left side of the depicted inter-pixel separation section 54. However, the opening 60 may alternatively have the enlarged opening 61-2 on the right side of FIG. 3 without having the enlarged opening 61-1.

As depicted in FIG. 3, even in the case where only one side of the inter-pixel separation section 54 is provided with an enlarged opening 61, the opening 60 can be formed to be wide, so that, for example, the embedding failure can be prevented from occurring when the filler 55 is embedded through the opening 60.

The enlarged opening 61 has a shape cut out obliquely with respect to a surface on the light-incident side of the semiconductor substrate 12. However, the resulting oblique surface is formed by a (111) plane. Since such an inclined surface of the enlarged opening 61 is formed by the (111) plane, it is possible to form a highly accurate inclined surface while reducing crystal defects by performing crystal anisotropic etching during formation.

As described above, the opening 60 in the inter-pixel separation section 54 is configured such that the (111) plane is exposed.

FIG. 4 is a diagram illustrating a surface including the opening 60 as viewed from above. FIG. 4 depicts nine (3 × 3) pixels 2a. In FIG. 4, thick lines indicate the opening 60 in which the enlarged opening 61 is formed, and thin lines indicate the opening 60 in which no enlarged opening 61 is formed.

As depicted in part A of FIG. 4, all four sides surrounding the pixel 2a can be formed into the opening 60 having the enlarged opening 61.

As depicted in part B of FIG. 4, two of the four sides surrounding the pixel 2a can be formed into the opening 60 having the enlarged opening 61. In the example depicted in part B of FIG. 4, the opening 60 having the enlarged opening 61 is formed on both the left and right sides of the depicted pixel 2a. Although part B of FIG. 4 depicts an example in which the enlarged opening 61 is formed in the inter-pixel separation section 54 in the vertical direction in FIG. 4, the enlarged opening 61 may alternatively be formed in the inter-pixel separation section 54 in the horizontal direction in FIG. 4.

As depicted in part C of FIG. 4, one of the four sides surrounding the pixel 2a can be formed into the opening 60 having the enlarged opening 61. When attention is paid on a pixel 2a-1 depicted in the example of part C of FIG. 4, the opening 60 having the enlarged opening 61 formed on one left-hand side of the pixel 2a-1. When attention is paid on a pixel 2a-2 positioned on the right next to the depicted pixel 2a-1, the opening 60 having the enlarged opening 61 is formed on one right-hand side of the depicted pixel 2a-2. When attention is paid on one pixel 2a as described above, an alternative configuration may be adopted in which one of the four sides surrounding the pixel 2a is formed into the opening 60 having the enlarged opening 61 while the other three sides are formed into the opening 60 having no enlarged opening 61.

Although not depicted, an alternative configuration may be adopted in which three of the four sides surrounding the pixel 2a are formed into the opening 60 having the enlarged opening 61.

### <Manufacture of Pixel 2a>

Manufacture of the pixel 2a will now be described with reference to FIGS. 5 and 6. In FIGS. 5 and 6, the upper parts depict an example of a simple cross-sectional configuration of the pixel 2a, the middle parts depict an example of the configuration of the pixel 2a between the inter-pixel separation sections 54 when viewed from above, and the lower parts depict an example of the cross-sectional configuration of the pixel 2a between the inter-pixel separation sections 54. In the following description, the pixel 2a including the opening 60 in which the enlarged openings 61-1 and 61-2 are formed like the pixel 2a depicted in FIG. 2 will be taken as an example.

In step S11, surface polishing is performed on the semiconductor substrate 12 on which an STI (Shallow Trench Isolation) 101, a SiN layer 102, and a polysilicon layer 103 are formed.

A portion where the SiN layer 102 and the polysilicon layer 103 are formed becomes the inter-pixel separation section 54. Referring to the plan view in the middle part of FIG. 5, the semiconductor substrate 12 has the SiN layer 102 that is formed so as to surround a region where the N-type semiconductor region 42 is formed. A portion where the SiN layer 102 is formed is the portion where the inter-pixel separation section 54 is formed. The inter-pixel separation section 54 is formed so as to surround the region where the N-type semiconductor region 42 is formed.

In step S12, a hard mask 111 is formed on the polished surface (the upper surface in FIG. 5). The hard mask 111 is formed, for example, by SiO.

In step S13, the hard mask 111 is processed by dry etching. In this process, a hole 113 sized to include a region to be opened as the opening 60, that is, a region to be formed as the enlarged opening 61, is formed. For example, in the case of the pixel 2a depicted in FIG. 2, the hole 113 acting as the opening 60 is formed to the width d2. The hole 113 is formed in a linear shape surrounding the pixel 2a and has the width d2 greater than the width d1, which is the line width of the inter-pixel separation section 54.

Referring to the plan view in the middle part of FIG. 5, the hard mask 111 is formed at the center of the pixel 2a, and the semiconductor substrate 12 exists between the hard mask 111 and the SiN layer 102. Referring to the cross-sectional view in the lower part of FIG. 5, the hole 113 is formed where the enlarged opening 61 is formed, and the semiconductor substrate 12 is exposed (not provided with the hard mask 111).

In step S14 (FIG. 6), alkaline wet processing is performed. When crystal anisotropic wet etching is performed by using an alkaline solution such as KOH, the etching progresses such that the (111) plane appears on the sidewall of the opening. Since wet etching is performed by using the alkaline solution in step S14, the enlarged opening 61 is formed in the semiconductor substrate 12 (silicon substrate), so that the resulting exposed inclined surface can be processed to form the (111) plane.

Referring to the cross-sectional view in the lower part of FIG. 6, the enlarged opening 61 inclined diagonally is formed in the semiconductor substrate 12. In step S14, the polysilicon layer 103 filled in the trench acting as the inter-pixel separation section 54 is also removed.

In step S15, the hard mask 111 is removed. In step S16, a protective film protecting the trench acting as the inter-pixel separation section 54 is removed, or more specifically, in this case, the SiN layer 102 is removed.

In subsequent steps, the pixel 2a is formed by forming the fixed charge film 62 and filling the trench with the filler 55. Since the enlarged opening 61 is formed, the opening 60 becomes larger. This makes it possible to obtain improved embeddability when forming the fixed charge film 62 and filling the filler 55.

In the formation of the enlarged opening 61, etching stops at the (111) plane. This makes it possible to prevent a chemical solution from leaking out of the interface of the hard mask 111 and reaching a portion to be left unprocessed or causing abnormal formation.

### <Second Embodiment>

FIG. 7 is a diagram illustrating an example of the cross-sectional configuration of a pixel 2b according to a second embodiment.

The imaging device 1 includes a semiconductor substrate 212, a multilayer wiring layer formed on the front side of the semiconductor substrate 212, and a support substrate (the latter two component elements are not depicted). The semiconductor substrate 212 includes silicon (Si), for example. The semiconductor substrate 212 is configured such that, for example, an N-type (second conductivity type) semiconductor region 242 is formed in a P-type (second conductivity type) semiconductor region 241 for each pixel 2b so as to form a photodiode PD (photoelectric conversion region) pixel by pixel. The P-type semiconductor region 241, which is provided on both the front and back surfaces of the semiconductor substrate 212, doubles as a hole charge accumulation region for suppressing the dark current.

As depicted in FIG. 7, the imaging device 1 includes an antireflection film 261, a transparent insulating film 246, and an on-chip lens 251. The antireflection film 261, the transparent insulating film 246, and the on-chip lens 251 are stacked on the semiconductor substrate 212 on which the N-type semiconductor region 242 including the photodiode PD is formed for each pixel 2b.

An uneven region 248 having a fine uneven structure is used to form the antireflection film 261, which prevents reflection of incident light, on the interface (light-receiving side interface) of the P-type semiconductor region 41 above the N-type semiconductor region 242, which serves as the charge accumulation region.

The antireflection film 261 has, for example, a layered structure in which a fixed charge film and an oxide film are stacked. For example, a thin insulating film having a high dielectric constant (High-k) and formed by an ALD (Atomic Layer Deposition) method can be used as the antireflection film 261. More specifically, the antireflection film 261 formed, for example, by hafnium oxide (HfO2), aluminum oxide (Al2O3), titanium oxide (TiO2), and STO (Strontium Titan Oxide) can be used. In the example of FIG. 7, the antireflection film 261 is configured by stacking a hafnium oxide film 262, an aluminum oxide film 263, and a silicon oxide film 264.

Further, a light-shielding film 249 is formed between the pixels 2b so as to be stacked on the antireflection film 261. The transparent insulating film 246 is formed on the entire back side (light-incident side) of the P-type semiconductor region 241. A color filter layer may be formed above the transparent insulating film 246 including the light-shielding film 249. For example, a configuration may be adopted in which a red, green, or blue color filter layer is formed for each pixel.

On the transparent insulating film 246, the on-chip lens 251 is formed for each pixel 2b. In the pixels 2b depicted in FIG. 7, an inter-pixel separation section 254 is formed on the semiconductor substrate 212 to separate the pixels 2b from each other. The inter-pixel separation section 254 is provided with an enlarged opening 281, as is the case with the inter-pixel separation section 54 in the first embodiment. The enlarged opening 281 corresponds to the enlarged opening 61 (FIG. 2).

An opening 280 in the inter-pixel separation section 254 depicted in FIG. 7 has an enlarged opening 281-1 in a leftward direction in FIG. 7 and an enlarged opening 281-2 in a rightward direction in FIG. 7. When a portion of the inter-pixel separation section 254 other than the opening 280 has a width d3 and the widest portion of the opening 280 has a width d4, the inter-pixel separation section 254 is configured such that the relational expression width d3

### < width d4 is true.

The following relation holds true: width of enlarged opening 281-1 + width of enlarged opening 281-2 + width d3 = width d4. The inter-pixel separation section 254 depicted in FIG. 7 is configured such that the enlarged openings 281-1 and 281-2 are provided on the left and right sides, respectively. However, as in the case described with reference to FIG. 3, an alternative configuration may be adopted in which only one of the enlarged openings 281-1 and 281-2 is provided.

The enlarged opening 281 has a shape cut out obliquely with respect to a surface on the light-incident side of the semiconductor substrate 212. However, the resulting oblique surface is formed by the

(111) plane. Since such an inclined surface of the enlarged opening 281 is formed by the (111) plane, it is possible to form a highly accurate inclined surface while reducing crystal defects by performing crystal anisotropic etching during formation. As described above, the opening 280 in the inter-pixel separation section 254 has a configuration in which the (111) plane is exposed.

The enlarged opening 281 may be formed on one, two, three, or four of the four sides of the pixel 2b, as in the case described with reference to FIG. 4.

Since the inter-pixel separation section 254 is configured as described above, adjacent pixels 2b are completely electrically isolated from each other by a filler 255 embedded in the trench. This makes it possible to prevent charge generated inside the semiconductor substrate 212 from leaking to the adjacent pixels 2b.

The inter-pixel separation section 254 (the trench constituting the inter-pixel separation section 254) may be configured to penetrate the semiconductor substrate 212 or configured to not penetrate the semiconductor substrate 212.

Recess portions formed in the uneven region 248 (hereinafter referred to as the recess portion 248 when one of the plurality of recesses formed in the uneven region 248 is described) are formed in a triangular shape in a cross-sectional view in FIG. 7. The recess portion 248 is not deep enough to reach the N-type semiconductor region 242 and is formed within the P-type semiconductor region 241.

The recess portion 248 is the interface between the antireflection film 261 and the transparent insulating film 246, is shaped to be recess in the depth direction with reference to the surface on which the light-shielding film 249 is formed, and is thus described as a recess portion. For example, when the upper surface of the N-type semiconductor region 242 is used as a reference surface, it can be said that a projection portion 248 having a projection shape is formed in the uneven region 248. Here, the surface on which the light-shielding film 249 is formed is defined as the reference surface, and the uneven region 248 is described as a recess portion that is formed in a recess shape in the depth direction from the reference surface.

Since the recess portion 248 is provided, the optical path length of light incident on the pixel 2b can be increased. The light incident on the pixel 2b hits the side surface of the recess portion 248, is reflected, hits the side surface of the recess portion 248 located at the opposite position, is reflected, and so on, repeating this process of reflection until it enters the N-type semiconductor region 242 (photodiode). Since the light incident is repeatedly reflected to increase the optical path length, a configuration may be adopted in which, for example, even incident light with a long wavelength, such as near-infrared light, can be efficiently absorbed.

### <Manufacture of Pixel 2b>

Manufacture of the pixel 2b will now be described with reference to FIGS. 8 and 9. In FIGS. 8 and 9, the upper parts depict an example of a simple cross-sectional configuration of the pixel 2b, the middle parts depict an example of the configuration of the pixel 2b between the inter-pixel separation sections 254 when viewed from above, and the lower parts depict an example of the cross-sectional configuration of the pixel 2b between the inter-pixel separation sections 254. In the following description, the pixel 2b including the opening 280 in which the enlarged openings 281-1 and 281-2 are formed like the pixel 2b depicted in FIG. 7 will be taken as an example.

In step S21, surface polishing is performed on the semiconductor substrate 212 on which an STI 301, a SiN layer 302, and a polysilicon layer 303 are formed. In step S22, a hard mask 311 is formed on the polished surface (the upper surface in FIG. 8). Steps S21 and S22 are basically similar to steps S11 and S12 (FIG. 5).

In step S23, the hard mask 311 is processed by dry etching. In this process, a hole 313 sized to include a region to be opened as the opening 280, that is, a region to be formed as the enlarged opening 281, is formed. For example, in the case of the pixel 2b depicted in FIG. 7, the hole 313 acting as the opening 280 is formed to the width d4. That is, the hole 113 is formed in a linear shape surrounding the pixel 2b, and has the width d4, which is greater than the line width d3 of the inter-pixel separation section 254.

In step S23, a hole 314 is additionally formed where the recess portion 248 is to be formed. Referring to the plan view in the middle part of FIG. 8, the hard mask 311 is formed at the center of the pixel 2b, and the hole 314, which is circular, is formed within the hard mask 311. The resulting shape is formed in such a manner that the semiconductor substrate 212 exists between the hard mask 311 and the SiN layer 302. Referring to the cross-sectional view in the lower part of FIG. 8, the hole 313 is formed where the enlarged opening 281 is formed, and the hole 314 is formed where the recess portion 248 is formed.

In step S24 (FIG. 9), alkaline wet processing is performed. When crystal anisotropic wet etching is performed by using an alkaline solution such as KOH, the etching progresses such that the (111) plane appears on the sidewall of the opening. Since wet etching is performed by using the alkaline solution in step S24, the enlarged opening 281 and the uneven region 248 are formed in the semiconductor substrate 12 (silicon substrate) such that the resulting exposed surface can be processed to form the (111) plane.

Referring to the cross-sectional view in the lower part of FIG. 9, the enlarged opening 281 inclined diagonally is formed in the semiconductor substrate 12. The recess portion 248 is also formed. In step S24, the polysilicon layer 303, which is filled in the trench acting as the inter-pixel separation section 254, is also removed.

In step S25, the hard mask 311 is removed. In step S26, the protective film protecting the trench acting as the inter-pixel separation section 254 is removed, or more specifically, in this case, the SiN layer 302, is removed.

In subsequent steps, the pixel 2b is formed by forming the antireflection film 261 and filling the trench with the filler 255. Since the enlarged opening 281 is formed, the opening 280 becomes larger. This makes it possible to obtain improved embeddability when forming the antireflection film 261 and filling the filler 255.

In the formation of the enlarged opening 281, etching stops at the (111) plane. This makes it possible to prevent a chemical solution from leaking out of the interface of the hard mask 311 and reaching a portion to be left unprocessed, such as the uneven region 248, or causing abnormal formation of the uneven region 248.

### <Alternative Manufacture of Pixel 2b>

Alternative manufacture of the pixel 2b will now be described with reference to FIGS. 10 and 11. In FIGS. 10 and 11, the upper parts depict an example of a simple cross-sectional configuration of the pixel 2b, the middle parts depict an example of the configuration of the pixel 2b between the inter-pixel separation sections 254 when viewed from above, and the lower parts depict an example of the cross-sectional configuration of the pixel 2b between the inter-pixel separation sections 254.

Steps S31 and S32 are similar to steps S21 and S22 (FIG. 8), so that their explanation will be omitted. In step S33, the hard mask 311 is processed by dry etching. In this process, a hole 351 sized to include a region to be opened as the opening 280, that is, a region to be formed as the enlarged opening 281, is formed.

In step S33, a hole 352 is additionally formed where the recess portion 248 is to be formed. Referring to the plan view in the middle part of FIG. 10, the hole 352 is formed in such a manner that the hard mask 311 remains in a region other than the region between the adjacent recess portions 248 in the uneven region 248, that is, left in a region other than the region excavated to form the recess portion 248. Stated differently, as indicated in the middle part of FIG. 10, which depicts step S33, the hole 352 is formed in such a manner that the hard mask 311 remains in a circular shape.

Referring to the cross-sectional view in the lower part of FIG. 10, the hole 351 is formed where the enlarged opening 281 is formed, and the hole 352 is formed where the recess portion 248 is formed.

In step S34 (FIG. 11), alkaline wet processing is performed. When crystal anisotropic wet etching is performed in the same manner as in step S24 (FIG. 9) by using an alkaline solution, such as KOH, the etching progresses in a region other than the region where the hard mask 311 exists such that the (111) plane appears on the sidewall of the opening. Since wet etching is performed by using the alkaline solution in step S34, the enlarged opening 281 and the uneven region 248 are formed in the semiconductor substrate 12 (silicon substrate), so that the resulting exposed surface can be processed to form the (111) plane.

Steps S35 and S36 are similar to steps S25 and S26 (FIG. 9), so that their explanation will be omitted.

In subsequent steps, the pixel 2b is formed by forming the antireflection film 261 and filling the trench with the filler 255. Since the enlarged opening 281 is formed, the opening 280 becomes larger. This makes it possible to obtain improved embeddability when forming the antireflection film 261 and filling the filler 255.

In the formation of the enlarged opening 281, etching stops at the (111) plane. This makes it possible to prevent a chemical solution from leaking out of the interface of the hard mask 311 and reaching a portion to be left unprocessed, such as the uneven region 248, or causing abnormal formation of the uneven region 248.

Referring, for example, to the pixel 2a depicted in FIG. 2, the foregoing embodiments have been described on the assumption that the enlarged opening 61 is formed on the light-incident side of the inter-pixel separation section 54. However, the enlarged opening 61 may alternatively be formed on a side opposite to the light-incident side of the inter-pixel separation section 54. For example, in a case where the light-incident side is processed to fill the filler 55 as described earlier at the time of formation of the inter-pixel separation section 54, the enlarged opening 61 is formed on the light-incident side. However, in a case where the side opposite to the light-incident surface is processed to form the inter-pixel separation section 54 and fill the filler 55, the enlarged opening 61 is formed on the side opposite to the light-incident surface.

The foregoing embodiments make it possible to improve the embeddability of fillers 55 and 255 and coating films (e.g., films used as the fixed charge film 62 and the antireflection film 261) by forming the openings 60 and 280 of the inter-pixel separation sections 54 and 254 to be larger. Consequently, the embedding failure can be prevented from occurring.

When the uneven region 248 is provided as in the case of the pixel 2b in the second embodiment, light diffraction occurs in the uneven region 248. This makes it possible to increase the optical path length within the silicon substrate and improve a saturated electron quantity Qs.

The inter-pixel separation sections 54 and 254 are formed by wet etching. Therefore, it is possible to reduce damage to the substrate interface of the openings 60 and 280 of the inter-pixel separation sections 54 and 254 and suppress the dark current in comparison with a case where the inter-pixel separation sections 54 and 254 are formed by dry etching.

### <Example of Application to Electronic Equipment>

The present technology is not limited to application to an imaging element. More specifically, the present technology is applicable to all electronic equipment that uses the imaging element in an image acquisition section (photoelectric conversion section), such as digital still cameras, video cameras, and other similar imaging devices, mobile terminal devices having an imaging function, and copy machines that use the imaging element in an image reading section. The imaging element may be in a single-chip form or in a module form obtained by combining an imaging section and a signal processing section or an optical system into a package to perform the imaging function.

FIG. 12 is a block diagram illustrating an example configuration of an imaging device that is the electronic equipment to which the present technology is applied.

An imaging element 1000 depicted in FIG. 12 includes an optical section 1001, an imaging element (image pickup device) 1002, and a DSP (Digital Signal Processor) circuit 1003. The optical section 1001 includes, for example, a lens group. The imaging element (image pickup device) 1002 uses the configuration of the imaging device 1 depicted in FIG. 1. The DSP circuit 1003 acts as a camera signal processing circuit. The imaging element 1000 additionally includes a frame memory 1004, a display section 1005, a recording section 1006, an operation section 1007, and a power supply section 1008. The DSP circuit 1003, the frame memory 1004, the display section 1005, the recording section 1006, the operation section 1007, and the power supply section 1008 are interconnected through a bus line 1009.

The optical section 1001 receives incident light (image light) from a subject, and forms an image on an imaging surface of the imaging element 1002. The imaging element 1002 obtains a pixel signal by converting the amount of incident light, which is used by the optical section 1001 to form the image on an imaging surface, to an electrical signal pixel by pixel, and outputs the obtained pixel signal. The imaging device 1 depicted in FIG. 1 can be used as the imaging element 1002.

The display section 1005 includes, for example, a thin display, such as an LCD (Liquid Crystal Display) or an organic EL (Electro Luminescence) display, and displays a moving or still image captured by the imaging element 1002. The recording section 1006 records the moving or still image, which is captured by the imaging element 1002, in a recording medium such as a hard disk or a semiconductor memory.

The operation section 1007 issues operation commands regarding various functions of the imaging element 1000 in accordance with user operations. The power supply section 1008 supplies various types of power to the DSP circuit 1003, the frame memory 1004, the display section 1005, the recording section 1006, and the operation section 1007 as needed for their operations.

### <Example of Application to Mobile Bodies>

The technology according to the present disclosure (the present technology) is applicable to various products. For example, the technology according to the present disclosure may be implemented as a device that is to be mounted in any one of various types of mobile bodies such as automobiles, electric vehicles, hybrid electric vehicles, motorcycles, bicycles, personal mobility devices, airplanes, drones, ships, and robots.

FIG. 13 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 13, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 13, an audio speaker 12061, a display section 12062, and an instrument panel 12063 are illustrated as the output device. The display section 12062 may, for example, include at least one of an on-board display and a head-up display.

FIG. 14 is a diagram depicting an example of the installation position of the imaging section 12031.

In FIG. 14, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 14 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In this document, the term "system" denotes the whole device that includes a plurality of devices.

It should be noted that advantages described in this document are merely illustrative and not restrictive. The present technology can additionally provide advantages other than those described in this document.

It should be noted that the embodiments of the present technology are not limited to those described above. Various changes may be made without departing from the spirit and scope of the present technology.

It should be noted that the present technology may additionally adopt the following configurations.
(1) An imaging element including:
   a photoelectric conversion region that is provided on a substrate; and
   an inter-pixel separation section that is disposed on the substrate and positioned between the photoelectric conversion regions adjacent to each other, in which
   an opening in the inter-pixel separation section has an inclined surface, and
   the inclined surface is formed by a (111) plane.
(2) The imaging element according to (1) above, in which the inclined surface is positioned toward a light-incident surface and provided on both ends of the inter-pixel separation section.
(3) The imaging element according to (1) above, in which the inclined surface is positioned toward a light-incident surface and provided on one end of the inter-pixel separation section.
(4) The imaging element according to any one of (1) to (3) above, in which the photoelectric conversion region includes an unevenly shaped region that is positioned toward the light-incident surface.
(5) The imaging element according to any one of (1) to (4) above, in which the inter-pixel separation section having the inclined surface is disposed on at least one of four sides surrounding the photoelectric conversion region.
(6) An imaging device including:
   an imaging element that includes
      a photoelectric conversion region that is provided on a substrate, and
      an inter-pixel separation section that is disposed on the substrate and positioned between the photoelectric conversion regions adjacent to each other,
      an opening in the inter-pixel separation section having an inclined surface formed by a (111) plane; and
   a processing section that processes signals from the imaging element.
(7) A manufacturing method for manufacturing an imaging element that includes a photoelectric conversion region that is provided on a substrate and an inter-pixel separation section that is disposed on the substrate and positioned between the photoelectric conversion regions adjacent to each other, the manufacturing method including:
   forming a hole, with a line width greater than a line width of the inter-pixel separation section, in a hard mask formed as a film on the substrate; and
   forming an inclined surface on the inter-pixel separation section by performing etching with an alkaline chemical solution.
(8) The manufacturing method according to (7) above, in which the etching is performed until a (111) plane is exposed.
(9) The manufacturing method according to (7) or (8) above, in which
   the photoelectric conversion region includes an unevenly shaped region that is positioned toward a light-incident surface, the manufacturing method including,
   when forming the hole, forming an additional hole in the unevenly shaped region, and
   forming both the unevenly shaped region and the inclined surface of the inter-pixel separation section by performing etching with the alkaline chemical solution.

### [Reference Signs List]

- 1:: Imaging device
- 2:: Pixel
- 3:: Pixel array section
- 4:: Vertical drive circuit
- 5:: Column signal processing circuit
- 6:: Horizontal drive circuit
- 7:: Output circuit
- 8:: Control circuit
- 9:: Vertical signal line
- 10:: Pixel drive wiring
- 11:: Horizontal signal line
- 12:: Semiconductor substrate
- 13:: Input/output terminal
- 41:: Semiconductor region
- 42:: Semiconductor region
- 46:: Transparent insulating film
- 48:: Recess portion
- 49:: Light-shielding film
- 51:: On-chip lens
- 54:: Inter-pixel separation section
- 55:: Filler
- 60:: Opening
- 61:: Enlarged opening
- 62:: Fixed charge film
- 102:: SiN film
- 103:: Polysilicon layer
- 111:: Hard mask
- 113:: Hole
- 202:: SiN film
- 212:: Semiconductor substrate
- 241:: P-type semiconductor region
- 242:: N-type semiconductor region
- 246:: Transparent insulating film
- 248:: Uneven region
- 249:: Light-shielding film
- 251:: On-chip lens
- 254:: Inter-pixel separation section
- 255:: Filler
- 261:: Antireflection film
- 262:: Hafnium oxide film
- 263:: Aluminum oxide film
- 264:: Silicon oxide film
- 280:: Opening
- 281:: Enlarged opening
- 302:: SiN film
- 303:: Polysilicon layer
- 311:: Hard mask
- 313, 314:: Hole
- 351, 352:: Hole

## Claims

1. An imaging element comprising:
a photoelectric conversion region that is provided on a substrate; and
an inter-pixel separation section that is disposed on the substrate and positioned between the photoelectric conversion regions adjacent to each other, wherein
an opening in the inter-pixel separation section has an inclined surface, and
the inclined surface is formed by a (111) plane.

2. The imaging element according to claim 1, wherein the inclined surface is positioned toward a light-incident surface and provided on both ends of the inter-pixel separation section.

3. The imaging element according to claim 1, wherein the inclined surface is positioned toward a light-incident surface and provided on one end of the inter-pixel separation section.

4. The imaging element according to claim 1, wherein the photoelectric conversion region includes an unevenly shaped region that is positioned toward a light-incident surface.

5. The imaging element according to claim 1, wherein the inter-pixel separation section having the inclined surface is disposed on at least one of four sides surrounding the photoelectric conversion region.

6. An imaging device comprising:
an imaging element that includes
a photoelectric conversion region that is provided on a substrate, and
an inter-pixel separation section that is disposed on the substrate and positioned between the photoelectric conversion regions adjacent to each other,
an opening in the inter-pixel separation section having an inclined surface formed by a (111) plane; and
a processing section that processes signals from the imaging element.

7. A manufacturing method for manufacturing an imaging element that includes a photoelectric conversion region that is provided on a substrate and an inter-pixel separation section that is disposed on the substrate and positioned between the photoelectric conversion regions adjacent to each other, the manufacturing method comprising:
forming a hole, with a line width greater than a line width of the inter-pixel separation section, in a hard mask formed as a film on the substrate; and
forming an inclined surface on the inter-pixel separation section by performing etching with an alkaline chemical solution.

8. The manufacturing method according to claim 7, wherein the etching is performed until a (111) plane is exposed.

9. The manufacturing method according to claim 7, wherein
the photoelectric conversion region includes an unevenly shaped region that is positioned toward a light-incident surface, the manufacturing method including,
when forming the hole, forming an additional hole in the unevenly shaped region, and
forming both the unevenly shaped region and the inclined surface of the inter-pixel separation section by performing etching with the alkaline chemical solution.
